(19) Europäisches Patentamt / European Patent Office / Office européen des brevets

(11) **EP 2 858 238 A1**

(12) **EUROPEAN PATENT APPLICATION**

(43) Date of publication:
08.04.2015 Bulletin 2015/15

(51) Int Cl.:
$H03F\ 1/32\ ^{(2006.01)}$     $H03F\ 1/02\ ^{(2006.01)}$
$H03F\ 3/195\ ^{(2006.01)}$     $H03F\ 3/24\ ^{(2006.01)}$
$H04B\ 17/00\ ^{(2015.01)}$     $H03G\ 3/00\ ^{(2006.01)}$
$H03G\ 3/30\ ^{(2006.01)}$     $H03F\ 3/217\ ^{(2006.01)}$

(21) Application number: 14190851.7

(22) Date of filing: 09.12.2011

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(30) Priority: 09.12.2010  US 421348 P
09.12.2010  US 421475 P
30.03.2011  US 201161469276 P
19.04.2011  US 201113089917
25.08.2011  US 201113218400

(62) Document number(s) of the earlier application(s) in accordance with Art. 76 EPC:
**11815602.5 / 2 649 724**

(71) Applicant: **RF Micro Devices, Inc.**
**Greensboro, NC 27409 (US)**

(72) Inventors:
• **Khlat, Nadim**
**F-31270 Cugnaux (FR)**
• **Kay, Michael R.**
**Summerfield, NC North Carolina 27358 (US)**
• **Gorisse, Philippe**
**F-31490 Brax (FR)**

(74) Representative: **Keane, Paul Fachtna**
**FRKelly**
**27 Clyde Road**
**Dublin 4 (IE)**

Remarks:
This application was filed on 29.10.2014 as a divisional application to the application mentioned under INID code 62.

(54) **Pseudo-envelope follower power management system with high frequency ripple current compensation**

(57) Embodiments disclosed in the detailed description relate to a pseudo-envelope follower power management system including a parallel amplifier and a multi-level converter cooperatively coupled to generate a power supply voltage at a power supply output coupled to a linear RF power amplifier. The parallel amplifier output is in communication with the power amplifier supply output. The parallel amplifier governs operation of the multi-level converter and regulates the power amplifier supply voltage base on a $V_{RAMP}$ signal. The parallel amplifier circuit includes an open loop high frequency compensation assist circuit that generates a high frequency ripple compensation current based on an estimate of the high frequency ripple currents contained in a ripple current of the power inductor. The high frequency ripple compensation current is injected into the parallel amplifier circuit output to cancel out high frequency ripple currents at the power amplifier supply output.

FIG.3A

EP 2 858 238 A1

**Description**

Related Applications

The present application claims priority to U.S. Provisional Patent Application No. 61/421,348, filed December 9, 2010.

The present application claims priority to U.S. Provisional Patent Application No. 61/421,475, filed December 9, 2010.

The present application claims priority to U.S. Provisional Patent Application No. 61/469,276, filed March 30, 2011.

The present application claims priority to and is a continuation-in-part of U.S. Patent Application No. 13/089,917, filed April 19, 2011, entitled "PSEUDO-ENVELOPE FOLLOWING POWER MANAGEMENT SYSTEM," which claims priority to U.S. Provisional Patent Application No. 61/325,659, filed April 19,2010.

The present application claims priority to and is a continuation-in-part of U.S. Patent Application No. 13/218,400, filed August 25, 2011, entitled "BOOST CHARGE-PUMP WITH FRACTIONAL RATIO AND OFFSET LOOP FOR SUPPLY MODULATION," which claims priority to U.S. Provisional Patent Application No. 61/376,877, filed August 25, 2010. U.S. Patent Application No. 13/218,400, is a continuation-in-part of U.S. Patent Application No. 13/089,917, filed April 19, 2011, which claims priority to U.S. Provisional Patent Application No. 61/325,659, filed April 19, 2010.

All of the applications listed above are hereby incorporated herein by reference in their entireties.

Field of the Disclosure

The embodiments described herein relate to a power management system for delivering current to a linear RF power amplifier. More particularly, the embodiments relate to the use of a pseudo-envelope tracker in a power management system of mobile communications equipment.

Background

Next-generation mobile devices are morphing from voice-centric telephones to message and multimedia-based "smart" phones that offer attractive new features. As an example, smart phones offer robust multimedia features such as web-browsing, audio and video playback and streaming, email access and a rich gaming environment. But even as manufacturers race to deliver ever more feature rich mobile devices, the challenge of powering them looms large.

In particular, the impressive growth of high bandwidth applications for radio-frequency (RF) handheld devices has led to increased demand for efficient power saving techniques to increase battery life. Because the power amplifier of the mobile device consumes a large percentage of the overall power budget of the mobile device, various power management systems have been proposed to increase the overall power efficiency of the power amplifier.

As an example, some power managements systems may use a $V_{RAMP}$ power control voltage to control the voltage presented on a power amplifier collector of a linear RF power amplifier. As another example, other power management schemes may use a buck converter power supply and a class AB amplifier in tandem to provide power to the linear RF power amplifier.

Even so, there remains a need to further improve the power efficiency of mobile devices to provide extended battery life. As a result, there is a need to improve the power management system of mobile devices.

Summary

Embodiments disclosed in the detailed description relate to a pseudo-envelope follower power management system including a parallel amplifier and a multi-level converter cooperatively coupled to generate a power supply voltage at a power supply output coupled to a linear RF power amplifier. The parallel amplifier output is in communication with the power amplifier supply output. The parallel amplifier governs operation of the multi-level converter and regulates the power amplifier supply voltage base on a $V_{RAMP}$ signal. The parallel amplifier circuit includes an open loop high frequency compensation assist circuit that generates a high frequency ripple compensation current based on an estimate of the high frequency ripple currents contained in a ripple current of the power inductor. The high frequency ripple compensation current is injected into the parallel amplifier circuit output to cancel out high frequency ripple currents at the power amplifier supply output.

Those skilled in the art will appreciate the scope of the disclosure and realize additional aspects thereof after reading the following detailed description in association with the accompanying drawings.

Brief Description of the Drawings

The accompanying drawings incorporated in and forming a part of this specification illustrate several aspects of the disclosure, and together with the description serve to explain the principles of the disclosure.

Figure 1A depicts an embodiment of a pseudo-envelope follower power management system for managing power supplied to a linear RF power amplifier.
Figure 1B depicts an embodiment of a pseudo-envelope follower power management system for managing power supplied to a linear RF power amplifier.
Figure 2A depicts an embodiment of the pseudo-envelope follower power management system of Figure 1A in further detail.
Figure 2B depicts an embodiment of the pseudo-envelope follower power management system of Figure 1B in further detail.

Figure 3A depicts an example embodiment of a pseudo-envelope follower power management system that includes a feedback delay compensation circuit in combination with a multi-level charge pump buck converter.

Figure 3B depicts an example embodiment of a pseudo-envelope follower power management system that includes a feedback delay compensation circuit in combination with a buck converter.

Figure 4A depicts a block diagram of an embodiment of the feedback delay compensation circuit of Figure 3A and Figure 3B.

Figure 4B depicts another embodiment of the feedback delay compensation circuit of Figure 3A and Figure 3B.

Detailed Description

The embodiments set forth below represent the necessary information to enable those skilled in the art to practice the disclosure and illustrate the best mode of practicing the disclosure. Upon reading the following description in light of the accompanying drawings, those skilled in the art will understand the concepts of the disclosure and will recognize applications of these concepts not particularly addressed herein. It should be understood that these concepts and applications fall within the scope of the disclosure and the accompanying claims.

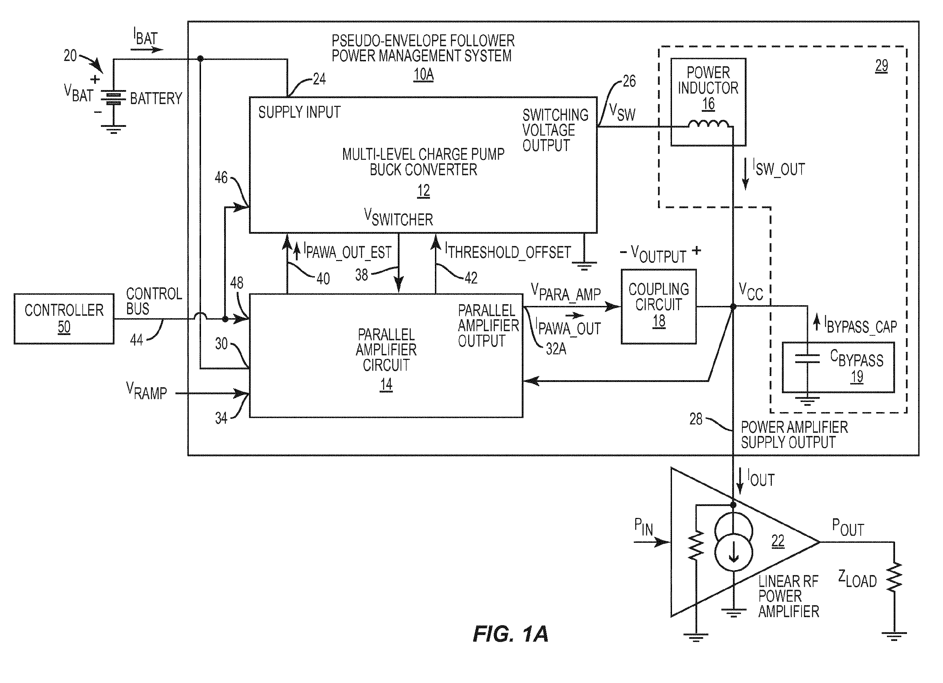

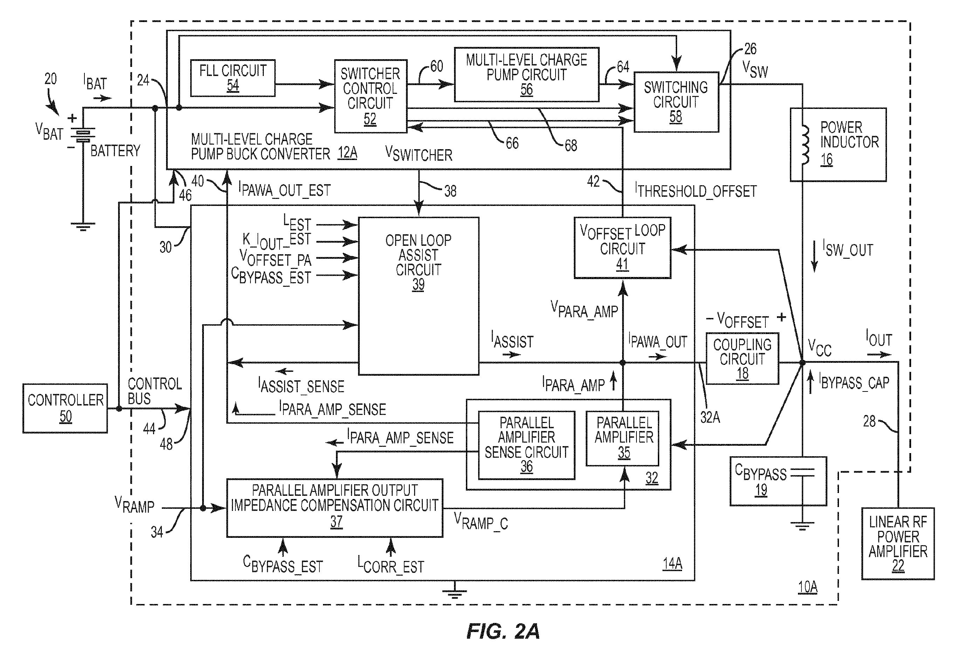

Figures 1A and 2A depict an example embodiment of pseudo-envelope follower power management system 10A including a multi-level charge pump buck converter 12, a parallel amplifier circuit 14, a power inductor 16, a coupling circuit 18, and a bypass capacitor 19. The bypass capacitor 19 has a bypass capacitor capacitance, $C_{BYPASS}$. The multi-level charge pump buck converter 12 and the parallel amplifier circuit 14 may be configured to operate in tandem to generate a power amplifier supply voltage, $V_{CC}$, at the power amplifier supply output 28 of the pseudo-envelope follower power management system 10A for a linear RF power amplifier 22. The power amplifier supply output 28 provides an output current, $I_{OUT}$, to the linear RF power amplifier 22. The linear RF power amplifier 22 may include a power amplifier input, $P_{IN}$, configured to receive a modulated RF signal and a power amplifier output, $P_{OUT}$, coupled to an output load, $Z_{LOAD}$. As an example, the output load, $Z_{LOAD}$, may be an antenna.

The multi-level charge pump buck converter 12 may include a supply input 24, ($V_{BAT}$), configured to receive a direct current (DC) voltage, $V_{BAT}$, from a battery 20 and a switching voltage output 26 configured to provide a switching voltage, $V_{SW}$. The switching voltage output 26 may be coupled to the power amplifier supply output 28 by the power inductor 16, where the power inductor 16 couples to a bypass capacitor 19 to form an output filter 29 for the switching voltage output 26 of the multi-level charge pump buck converter 12. The power inductor 16 provides an inductor current, $I_{SW\_OUT}$, to the power amplifier supply output 28. The parallel amplifier circuit 14 may include a parallel amplifier supply input 30 configured to receive the direct current (DC) voltage, $V_{BAT}$, from the battery 20, a parallel amplifier output 32A, a first control input 34 configured to receive a $V_{RAMP}$ signal, and a second control input configured to receive the power amplifier supply voltage, $V_{CC}$. The parallel amplifier output 32A of the parallel amplifier circuit 14 may be coupled to the power amplifier supply voltage $V_{CC}$, by a coupling circuit 18. The parallel amplifier output voltage, $V_{PARA\_AMP}$, is provided by the parallel amplifier circuit 14.

As an example, the parallel amplifier circuit 14 may generate the parallel amplifier output voltage, $V_{PARA\_AMP}$, based on the difference between the $V_{RAMP}$ signal and the power amplifier supply voltage, $V_{CC}$. Thus, the $V_{RAMP}$ signal may represent either an analog or digital signal that contains the required supply modulation information for a power amplifier collector of a linear RF power amplifier. Typically, the $V_{RAMP}$ signal is provided to the parallel amplifier circuit 14 as a differential analog signal to provide common mode rejection against any noise or spurs that could appear on this signal. The $V_{RAMP}$ signal may be a time domain signal, $V_{RAMP}(t)$, generated by a transceiver or modem and used to transmit radio-frequency (RF) signals. For example, the $V_{RAMP}$ signal may be generated by a digital baseband processing portion of the transceiver or modem, where the digital $V_{RAMP}$ signal, $V_{RAMP\_DIGITAL}$, is digital-to-analog converted to form the $V_{RAMP}$ signal in the analog domain. In some embodiments, the "analog" $V_{RAMP}$ signal is a differential signal. The transceiver or a modem may generate the $V_{RAMP}$ signal based upon a known RF modulation $Amp(t)*cos(2*pi*f_{RF}*t + Phase(t))$. The $V_{RAMP}$ signal may represent the target voltage for the power amplifier supply voltage, $V_{CC}$, to be generated at the power amplifier supply output 28 of the pseudo-envelope follower power management system 10A, where the pseudo-envelope follower power management system 10A provides the power amplifier supply voltage, $V_{CC}$, to the linear RF power amplifier 22. Also the $V_{RAMP}$ signal may be generated from a detector coupled to the RF input power amplifier.

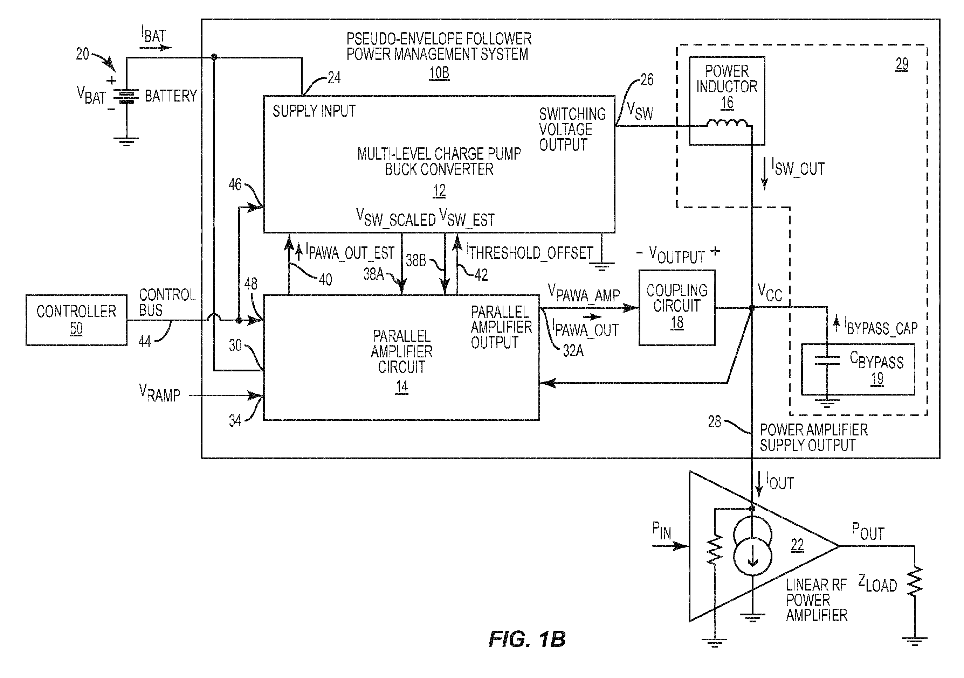

For example, the parallel amplifier circuit 14 includes a parallel amplifier output 32A that provides a parallel amplifier output voltage, $V_{PARA\_AMP}$, to the coupling circuit 18. The parallel amplifier output 32A sources a parallel amplifier circuit output current, $I_{PAWA\_OUT}$, to the coupling circuit 18. The parallel amplifier circuit 14, depicted in Figure 1A and Figure 1B, may provide a parallel amplifier circuit output current estimate 40, $I_{PAWA\_OUT\_EST}$, to the multi-level charge pump buck converter 12 as an estimate of the parallel amplifier circuit output current $I_{PAWA\_OUT}$, of the parallel amplifier circuit 14. Thus, the parallel amplifier circuit output current estimate 40, $I_{PAWA\_OUT\_EST}$, represents an estimate of the parallel amplifier circuit output current $I_{PAWA\_OUT}$, provided by the parallel amplifier circuit as a feedback signal to the multi-level charge pump buck converter 12. Based on the parallel amplifier circuit output current estimate 40, $I_{PAWA\_OUT\_EST}$, multi-level charge pump buck converter 12 may be configured to control the switching voltage, $V_{SW}$, provided at the switching voltage output 26 of the multi-level charge pump buck converter 12.

In some embodiments of the pseudo-envelope follower power management system 10A, depicted in Figure 1A, and the pseudo-envelope follower power management system 10B, depicted in Figure 1B, the coupling circuit 18 may be an offset capacitor, $C_{OFFSET}$. An offset voltage, $V_{OFFSET}$, may be developed across the coupling circuit 18. In other alternative embodiments, the coupling circuit may be a wire trace such that the offset voltage, $V_{OFFSET}$, between the parallel amplifier output voltage, $V_{PARA\_AMP}$, and the power amplifier supply voltage output, $V_{CC}$, is zero volts. In still other embodiments, the coupling circuit may be a transformer.

As an example, a pseudo-envelope follower power management system 10A, depicted in Figure 2A, is an example embodiment of the pseudo-envelope follower power management systems 10, depicted in Figure 1A. Unlike the pseudo-envelope follower power management systems 10, depicted in Figure 1A, the pseudo-envelope follower power management system 10A depicted in Figure 2A includes an embodiment of the multi-level charge pump buck converter 12A and a parallel amplifier circuit 14A having parallel amplifier circuitry 32. The parallel amplifier circuitry 32 includes a parallel amplifier 35 and a parallel amplifier sense circuit 36. The parallel amplifier circuit 14A further includes a parallel amplifier output impedance compensation circuit 37 configured to receive a $V_{RAMP}$ signal and provide a compensated $V_{RAMP}$ signal, $V_{RAMP\_C}$, as an input to the parallel amplifier 35. The parallel amplifier circuit 14A further includes a parallel amplifier output impedance compensation circuit 37 configured to receive the $V_{RAMP}$ signal and generate a compensated $V_{RAMP}$ signal, $V_{RAMP\_C}$, as a function of the $V_{RAMP}$ signal. The parallel amplifier 35 generates a parallel amplifier output current, $I_{PARA\_AMP}$, to produce a parallel amplifier output voltage, $V_{PARA\_AMP}$, at the parallel amplifier output 32A based on the difference between the compensated $V_{RAMP}$ signal, $V_{RAMP\_C}$ and the power amplifier supply voltage, $V_{CC}$, generated at power amplifier supply output 28. The parallel amplifier sense circuit 36 generates a scaled parallel amplifier output current estimate, $I_{PARA\_AMP\_SENSE}$, which is a fractional representation of the parallel amplifier output current, $I_{PARA\_AMP}$, generated by the parallel amplifier 35. Alternatively, in those embodiments of the parallel amplifier circuit 14 that do not include the parallel amplifier output impedance compensation circuit 37, the parallel amplifier 35 generates the parallel amplifier output current, $I_{PARA\_AMP}$, to product the parallel amplifier output voltage, $V_{PARA\_AMP}$, based on the difference between the $V_{RAMP}$ signal and the power amplifier supply voltage, $V_{CC}$.

The parallel amplifier circuit 14A may further include an open loop assist circuit 39 configured to receive the feed forward control signal 38, $V_{SWITCHER}$, the scaled parallel amplifier output current estimate, $I_{PARA\_AMP\_SENSE}$, and the $V_{RAMP}$ signal. In response to the feed forward control signal 38, $V_{SWITCHER}$, scaled parallel amplifier output current estimate, $I_{PARA\_AMP\_SENSE}$, and the $V_{RAMP}$ signal, the open loop assist circuit 39 may be configured to generate an open loop assist current, $I_{ASSIST}$. The open loop assist current, $I_{ASSIST}$, may be provided to the parallel amplifier output 32A. The parallel amplifier output current, $I_{PARA\_AMP}$, generated by the parallel amplifier 35 and the open loop assist circuit current, $I_{ASSIST}$, generated by the open loop assist circuit 39 may be combined to form the parallel amplifier circuit output current, $I_{PAWA\_OUT}$, of the parallel amplifier circuit 14A. The parallel amplifier circuit 14A may further include a $V_{OFFSET}$ loop circuit 41, configured to generate a threshold offset current 42, $I_{THRESHOLD\_OFFSET}$. The threshold offset current 42, $I_{THRESHOLD\_OFFSET}$, may be provided from the parallel amplifier circuit 14A as a feedback signal to the multi-level charge pump buck converter 12A. The $V_{OFFSET}$ loop circuit 41 may be configured to provide a threshold offset current 42, $I_{THRESHOLD\_OFFSET}$, as an estimate of the magnitude of the offset voltage, $V_{OFFSET}$, appearing across the coupling circuit 18. In those cases where the coupling circuit is a wire trace such that the offset voltage, $V_{OFFSET}$, is always zero volts, the parallel amplifier circuit 14A may not provide the threshold offset current 42, $I_{THRESHOLD\_OFFSET}$, to the multi-level charge pump buck converter 12A.

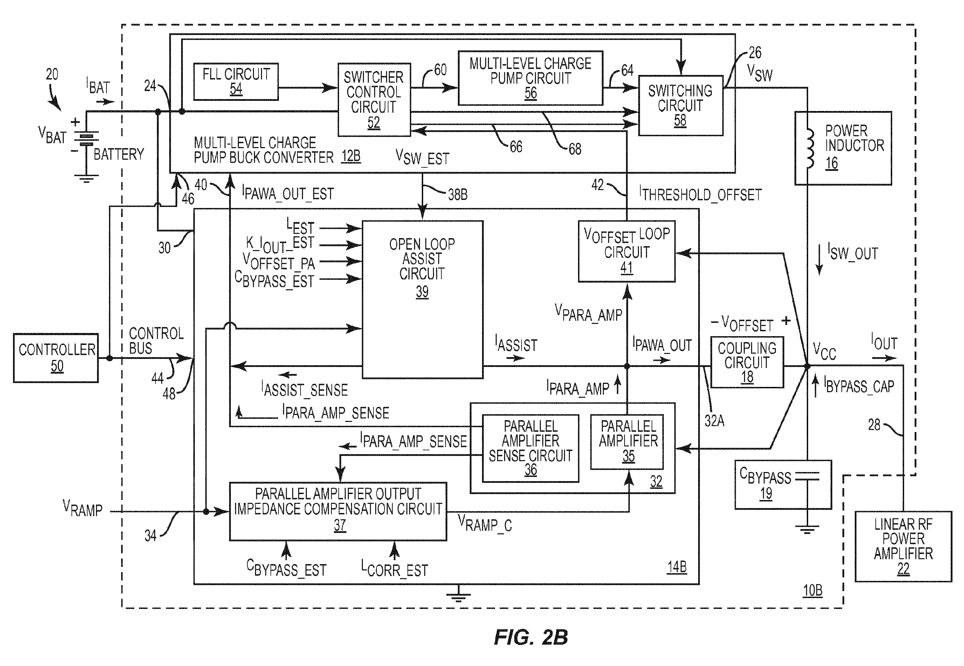

Another example is the pseudo-envelope follower power management system 10B depicted in Figure 2B, which is similar to the embodiment of the pseudo-envelope follower power management system 10B depicted in Figure 1B. The pseudo-envelope follower power management system 10B is operationally and functionally similar in form and function to the pseudo-envelope follower power management system 10A depicted in Figure 2A. However, unlike the pseudo-envelope follower power management system 10A depicted in Figure 2A, the pseudo-envelope follower power management system 10B depicted in Figure 2B includes a multi-level charge pump buck converter 12B configured to generate an estimated switching voltage output 38B, $V_{SW\_EST}$, and a parallel amplifier circuit 14B configured to receive the estimated switching voltage output 38B, $V_{SW\_EST}$, instead of the feed forward control signal 38, $V_{SWITCHER}$. Consequentially, as depicted in Figure 2B, the open loop assist circuit 39 of the parallel amplifier circuit 14B is configured to use only the estimated switching voltage output 38B, $V_{SW\_EST}$, instead of the feed forward control signal 38, $V_{SWITCHER}$. The estimated switching voltage output 38B, $V_{SW\_EST}$, provides an indication of the switching voltage, $V_{SW}$.

The generation of the parallel amplifier circuit output current estimate 40, $I_{PAWA\_OUT\_EST}$, depicted in Figure 1A and 1B will now be described with continuing reference to the embodiment of the parallel amplifier circuit 14A, depicted in Figure 2A, and the embodiment of the parallel amplifier circuit 14B depicted in Figure 2B. Embodiments of the parallel amplifier circuit 14A and the parallel amplifier circuit 14B, depicted in Figures 2A and 2B, may provide the parallel amplifier circuit output current estimate 40, $I_{PAWA\_OUT\_EST}$, where the parallel amplifier circuit output current estimate 40, $I_{PAWA\_OUT\_EST}$, includes a scaled parallel amplifier output current estimate, $I_{PARA\_AMP\_SENSE}$, and a scaled open loop assist circuit output current estimate, $I_{ASSIST\_SENSE}$. The scaled parallel amplifier output current estimate, $I_{PARA\_AMP\_SENSE}$, is a scaled estimate of the parallel amplifier output current, $I_{PARA\_AMP}$, generated by the parallel amplifier sense circuit 36 of the parallel amplifier circuitry 32. In some alternative embodiments, the parallel amplifier 35 may generate the scaled estimate of the parallel amplifier output current, $I_{PARA\_AMP\_SENSE}$, directly. The scaled open loop assist circuit current estimate, $I_{ASSIST\_SENSE}$, is a scaled estimate of the open loop assist circuit current, $I_{ASSIST}$. generated by the open loop assist circuit 39. In other alternative embodiments of the parallel amplifier circuit 14 depicted in Figure 1A and Figure 1B, the parallel amplifier circuit 14 does not include the open loop assist circuit 39. In those embodiments of the parallel amplifier circuit 14 depicted in Figure 1A and Figure 1B that do not include the open loop assist circuit 39, the parallel amplifier circuit output current estimate 40, $I_{PAWA\_OUT\_EST}$, may only be based on the scaled parallel amplifier output current estimate, $I_{PARA\_AMP\_SENSE}$.

Returning to Figures 1A and 1B, the pseudo-envelope follower power management systems 10A and 10B may further include a control bus 44 coupled to a controller 50. The control bus 44 may be coupled to a control bus interface 46 of the multi-level charge pump buck converter 12 and the control bus interface 48 of the parallel amplifier circuit 14. The controller 50 may include various logical blocks, modules, and circuits. The controller 50 may be implemented or performed with a processor, a Digital Signal Processor (DSP), an Application Specific Integrated Circuit (ASIC), a Field Programmable Gate Array (FPGA) or other programmable logic device, discrete gate or transistor logic, discrete hardware components, or any combination thereof designed to perform the functions described herein. A processor may be a microprocessor, but in the alternative, the processor may be any conventional processor, controller, microcontroller, or state machine. A processor may also be implemented as a combination of computing devices. As an example, a combination of computing devices may include a combination of a DSP and a microprocessor, a plurality of microprocessors, one or more microprocessors in conjunction with a DSP core, or any other such configuration. The controller may further include or be embodied in hardware and in computer executable instructions that are stored in memory, and may reside, for example, in Random Access Memory (RAM), flash memory, Read Only Memory (ROM), Electrically Programmable ROM (EPROM), Electrically Erasable Programmable ROM (EEPROM), registers, hard disk, a removable disk, a CD-ROM, or any other form of computer readable medium known in the art. An exemplary storage medium may be coupled to the processor such that a processor can read information from, and write information to, the storage medium. In the alternative, the storage medium or a portion of the storage medium may be integral to the processor. The processor and the storage medium may reside in an ASIC.

Figures 2A and 2B depict a pseudo-envelope follower power management system 10A and a pseudo-envelope follower power management system 10B, respectively, that include embodiments of the multi-level charge pump buck converter 12A and the multi-level charge pump buck converter 12B. As depicted in Figures 2A and 2B, some embodiments of the multi-level charge pump buck converter 12 of Figures 1A and 1B may include an FLL circuit 54 configured to interoperate with a switcher control circuit 52, as depicted in Figures 2A and 2B. Alternatively, some embodiments of the multi-level charge pump buck converter 12A and the multi-level charge pump buck converter 12B may not include an FLL circuit 54 or be configured to operate with the FLL circuit 54 being disabled.

As further depicted in Figures 2A and 2B, some embodiments of the switcher control circuit 52 may be configured to control the operation of the multi-level charge pump circuit 56 and the switching circuit 58 to generate the switching voltage, $V_{SW}$, on the switching voltage output 26 of the multi-level charge pump buck converter 12A or the multi-level charge pump buck converter 12B, respectively. For example, the switcher control circuit 52 may use a charge pump mode control signal 60 to configure the operation of the multi-level charge pump circuit 56 to provide a charge pump output 64 to the switching circuit 58. Alternatively, the switcher control circuit 52 may generate a series switch control signal 66 to configure the switching circuit 58 to provide the switching voltage, $V_{SW}$, substantially equal to the DC voltage, $V_{BAT}$, from the battery 20 via a first switching element coupled between the supply input 24 and the switching voltage output 26. As another example, the switcher control circuit 52 may configure the switching circuit 58 to provide the switching voltage, $V_{SW}$, through a second switching element coupled to ground such that the switching voltage, $V_{SW}$, is substantially equal to ground.

In addition, the parallel amplifier circuit 14A, depicted in Figure 2A, and the parallel amplifier circuit 14B, depicted in Figure 2B, may be configured to provide the parallel amplifier circuit output current estimate 40, $I_{PAWA\_OUT\_EST}$, and the threshold offset current 42, $I_{THRESHOLD\_OFFSET}$, to the switcher control circuit 52 in order to control the operation of the switcher control circuit 52. As discussed in detail below, some embodiments of the switcher control circuit 52 may be configured to receive and use the parallel amplifier circuit output current estimate 40, $I_{PAWA\_OUT\_EST}$, the threshold offset current 42, $I_{THRESHOLD\_OFFSET}$, and/or a combination thereof to control the operation of the switcher control circuit 52.

For example, the switcher control circuit 52 may use the parallel amplifier circuit output current estimate 40, $I_{PAWA\_OUT\_EST}$, the threshold offset current 42, $I_{THRESHOLD\_OFFSET}$, and/or a combination thereof to determine the magnitude of the voltage provided the switching voltage, $V_{SW}$, from the multi-level charge pump circuit 56.

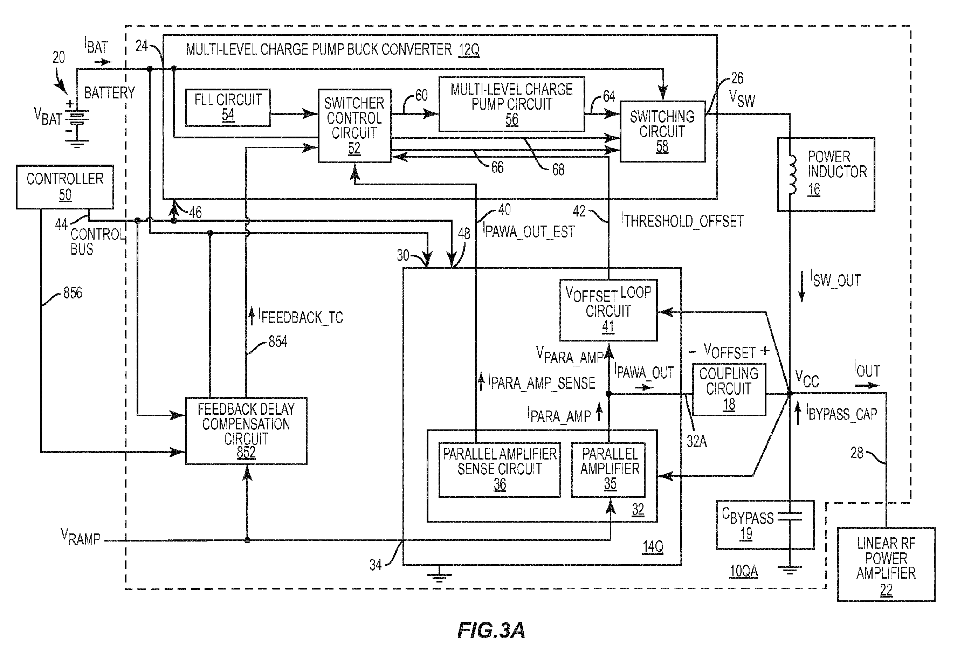

Figure 3A depicts an embodiment of a pseudo-envelope follower power management system 10QA. As a non-limiting example, the pseudo-envelope follower power management system 10QA includes a multi-level charge pump buck converter 12Q, a parallel amplifier circuit 14Q, the power inductor 16, the coupling circuit 18, the bypass capacitor 19, and the power amplifier supply output 28. Similar to the previously described embodiments of the pseudo-envelope follower power management systems, the multi-level charge pump buck converter 12Q and the parallel amplifier circuit 14QA of the embodiment of a pseudo-envelope follower power management system 10QA may be configured to operate in tandem with the power inductor 16, the coupling circuit 18, and the bypass capacitor 19 to generate a power amplifier supply voltage, $V_{CC}$, at the power amplifier supply output 28 of the for a linear RF power amplifier 22. The power inductor 16 is coupled between the switching voltage output 26 and the power amplifier supply output 28. The bypass capacitor 19 is coupled between the power amplifier supply output 28 and ground. In addition, the parallel amplifier circuit 14Q may be coupled to the battery 20 and the controller 50. The parallel amplifier circuit 14Q may include a parallel amplifier output 32A and be configured to receive the power amplifier supply voltage, $V_{CC}$, as a feedback voltage. The coupling circuit 18 may be coupled between the parallel amplifier output 32A and the power amplifier supply output 28. In addition, the parallel amplifier circuit 14Q may be configured to regulate the power amplifier supply voltage, $V_{CC}$, based on the difference between the $V_{RAMP}$ signal and the power amplifier supply voltage, $V_{CC}$. Likewise, as an example, the parallel amplifier circuit 14Q may be configured to provide the parallel amplifier circuit output current estimate 40, $I_{PAWA\_OUT\_EST}$, and the threshold offset current 42, $I_{THRESHOLD\_OFFSET}$, to the multi-level charge pump buck converter 12Q as feedback signals to govern the operation of the multi-level charge pump buck converter 12Q.

As an example, in the pseudo-envelope follower power management system 10QA depicted in Figure 3A, the parallel amplifier circuit 14Q acts as a master to control the power amplifier supply voltage, $V_{CC}$, at the power amplifier supply output 28 while controlling the multi-level charge pump buck converter 12Q. The parallel amplifier circuit 14Q regulates the power amplifier supply voltage, $V_{CC}$, by sourcing and sinking current through the coupling circuit 18, based on the received $V_{RAMP}$ signal, to compensate for either the over or under generation of the power inductor current, $I_{SW\_OUT}$, provided from the power inductor 16 due to changes in the switching voltage, $V_{SW}$, provided at the switching voltage output 26 of the multi-level charge pump buck converter 12Q. The parallel amplifier circuit 14Q controls the changes in the switching voltage, $V_{SW}$, provided at the switching voltage output 26 based on the parallel amplifier circuit output current estimate 40, $I_{PAWA\_OUT\_EST}$, and the threshold offset current 42, $I_{THRESHOLD\_OFFSET}$, provided to the multi-level charge pump buck converter 12Q as feedback signals. The parallel amplifier circuit 14Q may include a parallel amplifier circuit delay. The parallel amplifier circuit delay is the period of time in the $V_{RAMP}$ processing path between the first control input 34 and the power amplifier supply output 28. As an example, the parallel amplifier circuit delay of the embodiment of the parallel amplifier circuit 14Q depicted in Figure 3A may include the period of time between the $V_{RAMP}$ signal arriving at the first control input 34 and a change in the value of the power amplifier supply voltage, $V_{CC}$, generated by the parallel amplifier circuit 14Q in response to the $V_{RAMP}$ signal arriving at the first control input 34. The parallel amplifier circuit delay may be due to the internal propagation of the $V_{RAMP}$ signal through the parallel amplifier 35 and/or portions of the parallel amplifier circuitry 32 and pre-processing circuitry. Pre-processing delay associated with pre-processing circuitry may include the propagation delay between the first control input 34 and input of the parallel amplifier 35.

The pseudo-envelope follower power management system 10QA may include delays that can affect the operation of the switcher control circuit 52 and cause increases in the magnitude of the parallel amplifier output current, $I_{PARA\_AMP}$, provided by the parallel amplifier 35. The delays in the pseudo-envelope follower power management system 10QA may result in the parallel amplifier 35 either sourcing or sinking additional current to regulate the power amplifier supply voltage, $V_{CC}$. The increase in magnitude of the parallel amplifier output current, $I_{PARA\_AMP}$, provided by the parallel amplifier 35, may contribute to reduced power efficiency.

As a non-limiting example, in some cases, the delays may be internal to the switcher control circuit 52. In other cases, the delays that reduce the power efficiency of the pseudo-envelope follower power management system 10QA may be related to feedback delays. One example of feedback delay is the time period associated with generation of the scaled parallel amplifier output current estimate, $I_{PARA\_AMP\_SENSE}$, which is also referred to as a parallel amplifier feedback delay. For example, the parallel amplifier circuit 14Q may configure the parallel amplifier sense circuit 36 to generate the scaled parallel amplifier output current estimate, $I_{PARA\_AMP\_SENSE}$. The parallel amplifier circuit 14Q may use the scaled parallel amplifier output current estimate, $I_{PARA\_AMP\_SENSE}$, to provide at least a portion of the parallel amplifier circuit output current estimate 40, $I_{PAWA\_OUT\_EST}$. The parallel amplifier circuit output current estimate 40, $I_{PAWA\_OUT\_EST}$, is provided as a feedback signal to the multi-level charge pump buck converter 12Q such that the parallel amplifier circuit 14Q may control changes in the switching voltage, $V_{SW}$, based on the magnitude of the parallel amplifier circuit output current estimate 40, $I_{PAWA\_OUT\_EST}$, in order to minimize the magnitude of the parallel amplifier output current, $I_{PARA\_AMP}$, provided by the parallel amplifier 35. The feedback delay associated with generating and providing the scaled parallel amplifier output current estimate, $I_{PARA\_AMP\_SENSE}$, to the switcher control circuit 52 may delay the response of the multi-level charge pump buck converter 12Q to changes in the $V_{RAMP}$ signal. As a result, the response of the multi-level charge pump buck converter 12Q to a change in the $V_{RAMP}$ signal may be delayed such that the inductor current provided from the power inductor 16 may not correlate to the change in the target voltage level of the power amplifier supply voltage $V_{CC}$, which is represented by the $V_{RAMP}$ signal. As a result, the parallel amplifier output current, $I_{PARA\_AMP}$, sourced or sunk by the parallel amplifier 35 may be increased due to the feedback delay associated with generation of the scaled parallel amplifier output current estimate, $I_{PARA\_AMP\_SENSE}$, due to the lag in the response time of the multi-level charge pump buck converter 12Q. By minimizing the magnitude of the parallel amplifier output current, $I_{PARA\_AMP}$, provided by the parallel amplifier 35, the power efficiency of the pseudo-envelope follower power management system 10QA may be improved.

The parallel amplifier circuit 14Q may have a parallel amplifier circuit feedback delay associated with generation of the parallel amplifier circuit output current estimate 40, $I_{PAWA\_OUT\_EST}$, which is an estimate of the parallel amplifier circuit output current, $I_{PAWA\_OUT}$. In order to compensate for the delays in the pseudo-envelope follower power management system 10QA that may contribute to reduced power efficiency, the example embodiment of the pseudo-envelope follower power management system 10QA depicted in Figure 3A further includes a feedback delay compensation circuit 852 configured to minimize the negative impact of feedback delay on the power conversion efficiency of the pseudo-envelope follower power management system 10QA.

In some embodiments of the pseudo-envelope follower power management system 10QA, the feedback delay compensation circuit 852 may be incorporated into the multi-level charge pump buck converter 12Q. For the sake of simplicity of description of operation of the feedback delay compensation circuit 852, and not by way of limitation, the operation and functionality of the multi-level charge pump buck converter 12Q may be similar to the operation and function of either the multi-level charge pump buck converter 12A, depicted in Figure 2A, or the multi-level charge pump buck converter 12B, depicted in Figure 2B. Also, for the sake of simplicity of description of the feedback delay compensation circuit 852, and not by way of limitation, neither the feed forward control signal 38, $V_{SWITCHER}$, nor the estimated switching voltage output 38B, $V_{SW\_EST}$, are depicted in Figure 3A.

In some embodiments of the pseudo-envelope follower power management system 10QA, the feedback delay compensation circuit may be incorporated into the multi-level charge pump buck converter 12Q. However, for the sake of simplicity of description, and not by way of limitation, the feedback delay compensation circuit 852, depicted in Figure 3A, is shown as being separate from the multi-level charge pump buck converter 12Q.

Returning to the description of the feedback delay compensation circuit 852 depicted in Figure 3A, some example embodiments of the feedback delay compensation circuit 852 may provide a feedback delay compensation signal 854, $I_{FEEDBACK\_TC}$, to the multi-level charge pump buck converter 12Q. As depicted in Figure 3A, the switcher control circuit 52 may be configured to receive the parallel amplifier circuit output current estimate 40, $I_{PAWA\_OUT\_EST}$, and the threshold offset current 42, $I_{THRESHOLD\_OFFSET}$, and the feedback delay compensation signal 854, $I_{FEEDBACK\_TC}$ to govern the operation of the multi-level charge pump circuit 56 and the switching circuit 58 to control or govern the switching voltage, $V_{SW}$, provided at the switching voltage output 26 of the multi-level charge pump buck converter 12Q.

Figure 3A further depicts that the feedback delay compensation circuit 852 may be coupled to the battery 20 and configured to communicate with the controller 50 via the control bus 44. The feedback delay compensation circuit 852 may generate the feedback delay compensation signal 854, $i_{FEEDBACK\_TC}$, based on a slope of a derivative of the $V_{RAMP}$ signal. For example, the feedback delay compensation circuit 852 may determine the slope of the derivative of the $V_{RAMP}$ signal by high pass filtering the $V_{RAMP}$ signal with a capacitor/resistor network (not shown), where the capacitor/resistor network (not shown) has a high pass corner frequency, $f_{HP\_CF}$. Alternatively, the feedback delay compensation circuit 852 may determine the slope of the derivative of the $V_{RAMP}$ signal by high pass filtering the $V_{RAMP}$ signal with an active filter (not shown) to generate the derivative of the $V_{RAMP}$ signal, where the active filter (not shown) has a high pass corner frequency, $f_{HP\_CF}$.

In addition, in some embodiments, the feedback delay compensation circuit 852 may be coupled to the controller via the control bus 44, a capacitor array control bus 856, or a combination thereof. In some embodiments, the controller 50 may be configured to modify the high pass corner frequency, $f_{HP\_CF}$, and control the 90 degree phase lead of the high pass filtering response in order to maximize the power efficiency of either the parallel amplifier 35 or the pseudo-envelope follower power management system 10QA as a whole.

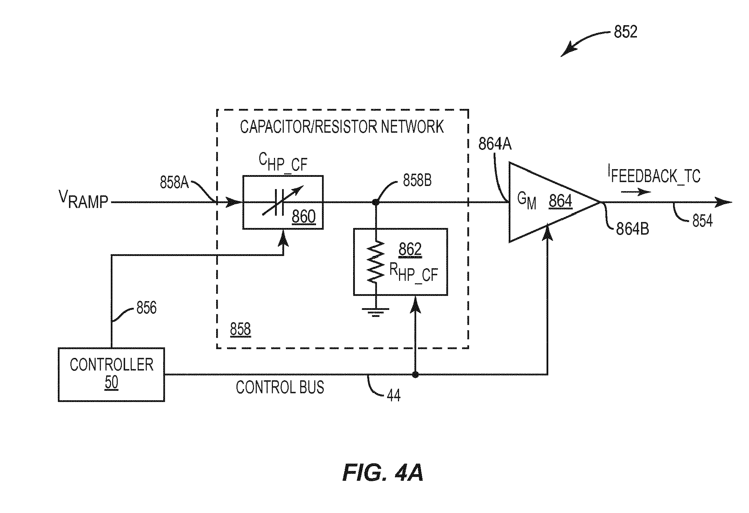

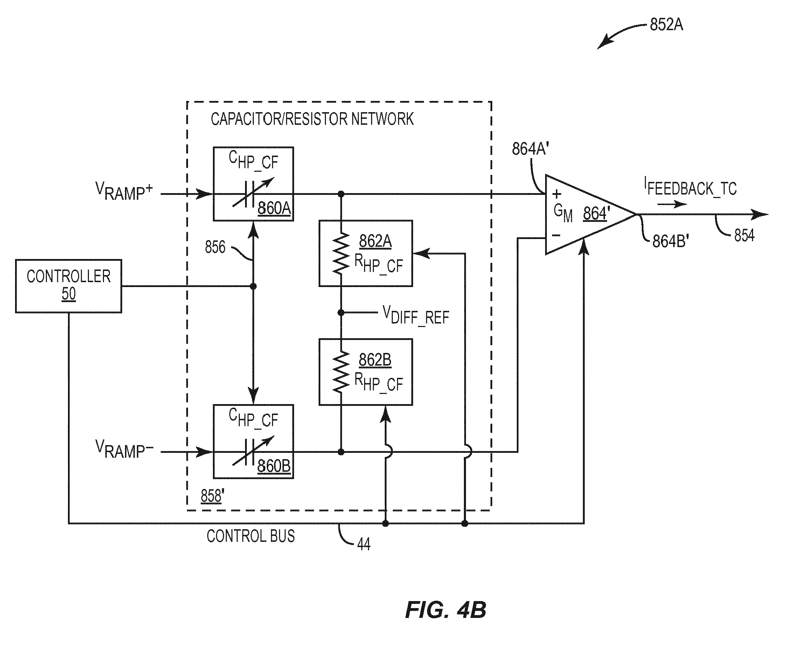

Prior to discussing the operation of the multi-level charge pump buck converter 12Q with respect to the feedback delay compensation signal 854, $I_{FEEDBACK\_TC}$, the embodiments of the feedback delay compensation circuit 852 depicted in Figure 4A and Figure 4B will be described. Figure 4B depicts a feedback delay compensation circuit 852A, which is a differential embodiment of the feedback delay compensation circuit 852, depicted in Figure 4A. As depicted in Figure 4B, the $V_{RAMP}$ signal may be a differential $V_{RAMP}$ signal having a non-inverted $V_{RAMP}$ signal component, $V_{RAMP}+$, and an inverted $V_{RAMP}$ signal component, $V_{RAMP}-$.

Figure 4A depicts an example embodiment of the feedback delay compensation circuit 852, which will be discussed with continuing reference to Figure 3A. The feedback delay compensation circuit 852 includes a capacitor/resistor network 858 having a high pass derivative filter capacitor 860 and a high pass derivative filter resistor 862 and a Gm feedback compensation circuit 864.

The Gm feedback compensation circuit 864 may include an input port 864A and a feedback delay compensation signal output 864B configured to provide the feedback delay compensation signal 854, $I_{FEEDBACK\_TC}$. The capacitor/resistor network 858 may have an input port 858A configured to receive the $V_{RAMP}$ signal. The capacitor/resistor network 858 may have an output port 858B coupled to the input port 864A of the Gm feedback compensation circuit 864. The high pass derivative filter capacitor 860 is coupled between the input port 858A of the capacitor/resistor network 858 and the output port of the capacitor/resistor network 858. The high pass derivative filter resistor 862 is coupled between the output port of the capacitor/resistor network 858 and ground. The output port of the capacitor/resistor network 858 is coupled to the input port 864A of the Gm feedback compensation circuit 864.

The high pass derivative filter capacitor 860 may have a capacitance level substantially equal to a high pass corner frequency capacitance, $C_{HP\_CF}$. The high pass derivative filter resistor 862 may have a resistance level substantially equal to a high pass corner frequency resistance, $R_{HP\_CF}$. The high pass derivative filter capacitor 860 and the high pass derivative filter resistor 862 of the capacitor/resistor network 858 may be configured to form a high pass filter. The capacitor/resistor network 858 high pass filters the $V_{RAMP}$ signal to generate a high pass filtered $V_{RAMP}$ signal. The high pass filtered $V_{RAMP}$ signal provides a 90 degree phase lead below the high pass corner frequency, $f_{HP\_CF}$, of the capacitor/resistor network as compared to the $V_{RAMP}$ signal, where the slope of the derivative of the $V_{RAMP}$ signal provides an indication of whether the target voltage for the power amplifier supply voltage, $V_{CC}$, is increasing or decreasing.

Because the derivative of the $V_{RAMP}$ signal is used to generate the feedback delay compensation signal 854, $I_{FEEDBACK\_TC}$, the feedback delay compensation signal 854, $I_{FEEDBACK\_TC}$, effectively provides a feedback current to the switcher control circuit 52 that has a 90 degree phase lead, as compared to the $V_{RAMP}$ signal, below the high pass corner frequency, $f_{HP\_CF}$, of the capacitor/resistor network 858. As a result, the feedback delay compensation signal 854, $I_{FEEDBACK\_TC}$, provides an early indication of the direction in which the target voltage for the power amplifier supply voltage, $V_{CC}$, is headed based to the switcher control circuit 52. For example, if the slope of the derivative of the $V_{RAMP}$ signal is positive, the feedback delay compensation signal 854, $I_{FEEDBACK\_TC}$, provides an indication that the target voltage for the power amplifier supply voltage, $V_{CC}$, is increasing to the switcher control circuit 52, which is independent of the parallel amplifier circuit output current estimate 40, $I_{PAWA\_OUT\_EST}$. Alternatively, when the slope of the derivative of the $V_{RAMP}$ signal is negative, the feedback delay compensation signal 854, $I_{FEEDBACK\_TC}$, provides an indication that the target voltage for the power amplifier supply voltage, $V_{CC}$, is decreasing to the switcher control circuit 52, which is also is independent of the parallel amplifier circuit output current estimate 40, $I_{PAWA\_OUT\_EST}$. For example, the switcher control circuit 52 may be configured to use the information contained in the feedback delay compensation signal 854, $I_{FEEDBACK\_TC}$, to raise or lower the effective thresholds used by the switcher control circuit 52 to control changes between modes of operation of the multi-level charge pump buck converter 12Q, where each mode of operation corresponds to a particular voltage level of the switching voltage, $V_{SW}$, provided at the switching voltage output 26 to the power inductor 16.

The capacitor/resistor network 858 includes a high pass corner time constant, $\tau_{HF\_CF}$, substantially equal to the product of the high pass corner frequency capacitance, $C_{HP\_CF}$, and the high pass frequency resistance, $R_{HP\_CF}$. The high pass corner frequency, $f_{HP\_CF}$, of the capacitor/resistor network 858 is provided by equation (1) as follows:

$$(1) \quad f_{\text{HP\_CF}} = \frac{1}{\left(2 \times \Pi \times C_{HP\_CF} \times R_{HP\_CF}\right)}$$

As will be discussed, in some embodiments of the feedback delay compensation circuit 852, the high pass corner frequency, $f_{HP\_CF}$, of the capacitor/resistor network 858 may be configured by the controller 50. For example, in some embodiments, the high pass corner frequency resistance, $R_{HP\_CF}$, of the high pass derivative filter resistor 862 may be a programmable resistance. For example, the high pass derivative filter resistor 862 may be a binary weighted resistor array. In other embodiments, the high pass derivative filter resistor 862 may be a fixed value resistor. Likewise, the high pass corner frequency capacitance, $C_{HP\_CF}$, of the high pass derivative filter capacitor 860 may be a programmable capacitance. For example, the high pass derivative filter capacitor 860 may be a binary weighted capacitor array. However, in some embodiments, the high pass derivative filter capacitor 860 may be a fixed value capacitor.

In some embodiments of the feedback delay compensation circuit 852, the controller 50 may be configured to change the high pass corner frequency, $f_{HP\_CF}$, to between 30 MHz to 50 MHz in 5 MHz increments. In other embodiments of the feedback delay compensation circuit 852, the feedback delay compensation circuit 852 may be configured to limit the bandwidth of the feedback delay compensation signal 854, $I_{FEEDBACK\_TC}$, to improved stability.

The Gm feedback compensation circuit 864 may be configured to generate the feedback delay compensation signal 854, $I_{FEEDBACK\_TC}$, based on the slope of the derivative output response of the capacitor/resistor network 858. In other words, the Gm feedback compensation circuit 864 may be configured to generate the feedback delay compensation signal 854, $I_{FEEDBACK\_TC}$, based on the high pass filtered $V_{RAMP}$ signal, where the slope of the high pass filtered $V_{RAMP}$ signal indicates the direction in which the target voltage for the power amplifier supply voltage, $V_{CC}$, is heading in response to the $V_{RAMP}$ signal. Because the feedback delay compensation signal 854, $I_{FEEDBACK\_TC}$, is based on the derivative of the $V_{RAMP}$ signal, the rate of change of the $V_{RAMP}$ signal results in a change in the magnitude (positive or negative) of the feedback delay compensation signal 854, $I_{FEEDBACK\_TC}$. For example, when the slope of the derivative of the $V_{RAMP}$ signal is positive, the Gm feedback compensation circuit 864 may be configured to source current such that the feedback delay compensation signal 854, $I_{FEEDBACK\_TC}$, has a positive magnitude. However, when the slope of the derivative of the $V_{RAMP}$ signal is negative, the Gm feedback compensation circuit 864 may be configured to sink current such that the feedback delay compensation signal 854, $I_{FEEDBACK\_TC}$, has a negative magnitude. In addition, the greater the slope of the derivative of the $V_{RAMP}$ signal, the large the magnitude of the feedback delay compensation signal 854, $I_{FEEDBACK\_TC}$.

The Gm feedback compensation circuit 864 may be coupled to the controller 50 via control bus 44. The Gm feedback compensation circuit 864 may have a Gm feedback compensation transconductance, $Gm_{FEEDBACK\_TC}$. In some embodiments of the Gm feedback compensation circuit 864, the Gm feedback compensation transconductance, $Gm_{FEEDBACK\_TC}$, may be programmable by the controller 50. Accordingly, the controller 50 may adjust the magnitude of the feedback delay compensation signal 854, $I_{FEEDBACK\_TC}$, by increasing or decreasing the Gm feedback compensation transconductance, $Gm_{FEEDBACK\_TC}$. For example, in some cases, the controller 50 may increase or decrease the Gm feedback compensation transconductance, $Gm_{FEEDBACK\_TC}$, with an increment size of .1A/V, where $.7A/V \leq Gm_{FEEDBACK\_TC} \leq 1/3$ A/V.

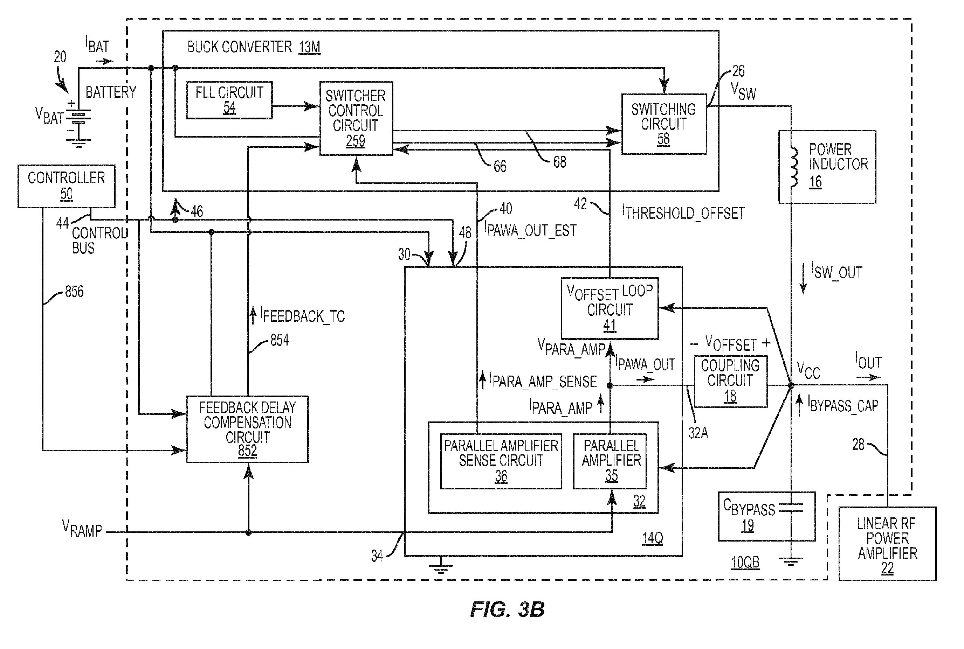

As an example, in some embodiments of the pseudo-envelope follower power management system 10QA, the effects of feedback delay on the power efficiency of the parallel amplifier circuit 14Q may vary depending on the operational mode of the communication device. For example, the parallel amplifier circuit feedback delay may change depending on the configuration of the parallel amplifier circuit 14Q and/or the operational mode of the communication device. Alternatively, depending on the signal processing path associated with the operational mode of the communication device, the feedback delay of the parallel amplifier circuit 14Q may vary. As another example, the parallel amplifier feedback delay may vary depending on the configuration of the operation of the pseudo-envelope follower power management system 10QA and/or the parallel amplifier 35. For example, the parallel amplifier delay may vary depending on the operational mode of the communication device or the band of operation that the communication device is using within a network. As another example, the feedback delay associated with the generation of the scaled high frequency ripple compensation current estimate 418, $I_{COR\_SENSE}$, may be dependent upon the band of operation of the communication device or the temporal alignment of the frequency ripple compensation assist current 414. Thus, in some embodiments, the controller 50 may configure the high pass corner frequency, $f_{HP\_CF}$, based on the operational state of the parallel amplifier circuit 14Q in order to compensate for increases or decrease in the feedback delays associated with generation of the parallel amplifier circuit output current estimate 40, $I_{PAWA\_OUT\_EST}$, in order to maximize the power efficiency of the parallel amplifier circuit 14Q, the parallel amplifier 35, or the pseudo-envelope follower power management system 10QA, depicted in Figure 3A, and the pseudo-envelope follower power management system 10QB, depicted in Figure 3B.

The controller 50 may configure the high pass corner frequency, $f_{HP\_CF}$, of the high pass filter to set the apparent gain of the feedback delay compensation circuit 852 at a given frequency. As a non-limiting example, some embodiments of the feedback delay compensation circuit 852 may be configured such that the high pass frequency resistance, $R_{HP\_CF}$, is substantially equal to 25.3 KΩ. In addition, the high pass derivative filter capacitor 860 may be binary capacitor array, where the high pass corner frequency capacitance, $C_{HP\_CF}$, may have a capacitance value that ranges between 0 Farads to 3pF in increments substantially equal to .2pF. When the capacitance of the high pass corner frequency capacitance, $C_{HP\_CF}$, equals zero Farads, the feedback delay compensation circuit 852 may be effectively disabled. For the case where the high pass corner frequency capacitance, $C_{HP\_CF}$, is configured to have a capacitance substantially equal to .2pF, an apparent gain of the high pass derivative filter capacitor 860 may be substantially equal to -12dBm at 10 MHz. However, for the case where the high pass corner frequency capacitance, $C_{HP\_CF}$, is configured to have a capacitance substantially equal to 3pF, the apparent gain of the high pass derivative filter capacitor 860 may be substantially equal to 10 dBm at 10 MHz. Thus, the aggressiveness of the feedback compensation provided by the feedback delay compensation circuit 852 may be configured by adjusting the high pass corner frequency, $f_{HP\_CF}$. As an example, as the high pass corner frequency capacitance, $C_{HP\_CF}$, increases, the high pass corner frequency, $f_{HP\_CF}$, decreases, which increases the apparent gain of the feedback delay compensation circuit 852. Because the apparent gain of the feedback delay compensation circuit 852 is increased, the magnitude of the feedback delay compensation signal 854, $I_{FEEDBACK\_TC}$, increases, which tends to improve the power efficiency of the parallel amplifier circuit 14Q. For example, as the apparent gain of the feedback delay compensation circuit 852 is increased, the magnitude of the parallel amplifier output current, $I_{PARA\_AMP}$, generated by the parallel amplifier 35 may tend to decrease. However, in the case where the apparent gain of the feedback delay compensation circuit 852 is too high, the switcher control circuit 52 may pre-maturely change the switching voltage, $V_{SW}$, which may increase the magnitude of the parallel amplifier output current, $I_{PARA\_AMP}$, generated by the parallel amplifier 35. Thus, depending on the operational mode of the pseudo-envelope follower power management system 10QA and/or the band of operation of the communication device, the controller 50 may configure the high pass corner frequency, $f_{HP\_CF}$, of the high pass filter to maximize power efficiency either the parallel amplifier 35 or the parallel amplifier circuit 14Q as a whole.

As another example, the controller 50 may configure the high pass corner time constant, $\tau_{HF\_CF}$, by programmably changing the capacitance of the high pass corner frequency capacitance $C_{HP\_CF}$, the resistance value of the high pass frequency resistance, $R_{HP\_CF}$, and/or a combination thereof. Similarly, the controller 50 may adjust the high pass corner frequency, $f_{HP\_CF}$, based on the operational state of the pseudo-envelope follower power management system 10QA in order to maximize power efficiency of the system. For example, during configuration of the pseudo-envelope follower power management system 10QA, the controller 50 may be configured to store high pass corner frequency parameters that correspond to various operational states of either the parallel amplifier 35, the pseudo-envelope follower power management system 10QA, and/or a combination thereof. Each of the stored high pass corner frequency parameters may be associated with a particular operational state of the parallel amplifier 35, the pseudo-envelope follower power management system 10QA, and/or a combination thereof. The high pass corner frequency parameters may include settings to adjust the value of the high pass corner frequency capacitance $C_{HP\_CF}$, the value of the high pass frequency resistance, $R_{HP\_CF}$, and/or a combination thereof. In some embodiments, only the high pass derivative filter capacitor 860 is configured to be programmable whereas the high pass derivative filter resistor 862 is configured to have a fixed value. In other embodiments, only the high pass derivative filter resistance 862 is configured to be programmable whereas the high pass derivative filter capacitor 860 is configured to have a fixed value.

As another example, the feedback delay compensation circuit 852 may be configured to set the high pass corner frequency, $f_{HP\_CF}$, to a first frequency value when the pseudo-envelope follower power management system 10QA is in a first operational mode and set the high pass corner frequency, $f_{HP\_CF}$, to a second frequency when the pseudo-envelope follower power management system 10QA is in a second operational mode in order to maximize the power efficiency of the pseudo-envelope follower power management system 10QA in each operation mode. Alternatively, the high pass corner frequency, $f_{HP\_CF}$, may be set only during calibration of the pseudo-envelope follower power management system 10QA. The high pass corner frequency, $f_{HP\_CF}$, may be independently set from the bandwidth of the feedback delay compensation signal 854, $I_{FEEDBACK\_TC}$. For example, the controller 50 may configure Gm feedback compensation circuit 864 to limit the frequency pass band of the Gm feedback compensation circuit 864 in order to the improve stability of the pseudo-envelope follower power management system 10QA when operating in a particular operational mode. For example, for the case where the feedback delay of the parallel amplifier circuit is 5ns, the controller 50 may configure the high pass corner frequency, $f_{HP\_CF}$, to be substantial equal to 40MHz and the Gm feedback compensation transconductance, $Gm_{FEEDBACK\_TC}$, to be substantially equal to 1 A/V in order to maximize the power efficiency of the parallel amplifier 35.

As an example, the high pass derivative filter capacitor 860 may be coupled to the controller 50 via the capacitor array control bus 856. The high pass derivative filter capacitor 860 may be configured to be a binary weighted programmable capacitor array similar to the programmable capacitor array 758, depicted in Figure 36. The high pass derivative filter capacitor 860 may include several capacitors arranged in parallel that may be switched in parallel to provide an equivalent capacitance level. The high pass derivative filter capacitor 860 may also have a bypass mode to set the high pass corner frequency capacitance, $C_{HP\_CF}$, equal to zero Farads. The capacitor array control bus 856 may be multibit control bus configured to selectively switch in or out one or more of the binary weighted capacitors that are in a parallel arrangement or to switch into the bypass mode. Similar to the variable capacitance control bus 760, CNTR_CD (5:1), depicted in Figure 36, the capacitor array control bus 856 may include multiple bits that may form a binary word that may be used by the controller 50 to control the capacitance of the high pass derivative filter capacitor 860. The high pass derivative filter capacitor 860 may be configured to be a binary weighted programmable capacitor array such that the effective capacitance of the high pass derivative filter capacitor 860 may be a linearly controlled capacitance similar to the programmable capacitor array 758, depicted in Figure 36. For example, in some embodiments of the feedback delay compensation circuit 852, the high pass corner frequency capacitance, $C_{HP\_CF}$ of the high pass derivative filter capacitor 860 may be controlled by controller 50 to have a capacitance range of between .2pF to 3pF. As a result, the high pass filter having a high pass corner frequency, $f_{HP\_CF}$, of the capacitor/resistor network 858 may be adjusted by modifying the high pass corner frequency capacitance, $C_{HP\_CF}$, of the high pass derivative filter capacitor 860.

Figure 4B depicts a differential feedback delay compensation circuit 852A, which is another embodiment of the feedback delay compensation circuit 852 depicted in Figure 4A. The differential feedback delay compensation circuit 852A will be discussed with continuing reference to Figure 3A. The differential feedback delay compensation circuit 852A functions in a similar fashion as the previously described feedback delay compensation circuit 852, depicted in Figure 4A, except the signal processing is done differentially. The differential feedback delay compensation circuit 852A may be configured to generate the feedback delay compensation signal 854, $I_{FEEDBACK\_TC}$, based on the derivative the differential $V_{RAMP}$ signal.

Figure 4B depicts a differential capacitor/resistor network 858' configured to receive the differential $V_{RAMP}$ signal. In some embodiments, the differential capacitor/resistor network 858' is a differential high pass filter. Similar to the capacitor/resistor network 858, depicted in Figure 4A, the differential capacitor/resistor network 858' may act as a high pass filter to provide the derivative of the differential $V_{RAMP}$ signal, where the high pass filter has a high pass corner frequency, $f_{HP\_CF}$, that corresponds to the high pass corner time constant, $\tau_{HF\_CF}$. The differential capacitor/resistor network 858' includes a non-inverted high pass filter input configured to receive the non-inverted $V_{RAMP}+$ signal component and an inverted high pass filter input configured to receive the inverted $V_{RAMP}$ signal component, $V_{RAMP}-$. The differential capacitor/resistor network 858' may include a non-inverted high pass filtered output and an inverted high pass filtered output. The non-inverted high pass filtered output may be formed by coupling a first high pass derivative filter capacitor 860A to a first high pass derivative filter resistor 862A, where the first high pass derivative filter resistor 862A is coupled between the non-inverted high pass filtered output and a differential reference voltage, $V_{DIFF\_REF}$. The inverted high pass filtered output may be formed by coupling a second high pass derivative filter capacitor 860B to a second high pass derivative filter resistor 862B, where the second high pass derivative filter resistor 862B is coupled between the inverted high pass filtered output and the differential reference voltage, $V_{DIFF\_REF}$. The first high pass derivative filter capacitor 860A may be coupled between the non-inverted high pass filter input and the non-inverted high pass filtered output. The second high pass derivative filter capacitor 860B may be coupled between the inverted high pass filter input and the inverted high pass filtered output. The differential reference voltage, $V_{DIFF\_REF}$, may provide a common voltage reference for the non-inverted $V_{RAMP}$ signal component, $V_{RAMP}+$, and the inverted $V_{RAMP}$ signal component, $V_{RAMP}-$. In some embodiments the differential reference voltage, $V_{DIFF\_REF}$, is tied to ground. The differential capacitor/resistor network 858' high pass filters the differential $V_{RAMP}$ signal to generate a high pass filtered $V_{RAMP}$ signal, where the high pass filtered $V_{RAMP}$ signal is used as the derivative of the $V_{RAMP}$ signal. The high pass filtered $V_{RAMP}$ signal is provided as a differential signal between the non-inverted high pass filtered output and the inverted high pass filtered output.

The first high pass derivative filter capacitor 860A and the second high pass derivative filter capacitor 860B may each be configured as a binary capacitor array that is similar in form and function to the high pass derivative filter capacitor 860. Via the capacitor array control bus 856, the controller 50 may configure the capacitance value of the first high pass derivative filter capacitor 860A and the second high pass derivative filter capacitor 860B to be substantially equal to the high pass corner frequency capacitance, $C_{HP\_CF}$. As a non-limiting example, the high pass corner frequency capacitance, $C_{HP\_CF}$, may have a capacitance between 0 farads and 3pF in increments substantially equal to .2pF. When the capacitance of the high pass corner frequency capacitance, $C_{HP\_CF}$, equals zero, the differential feedback delay compensation circuit 852A may be effectively disabled. Similarly, in some embodiments, the first high pass derivative filter resistor 862A and the second high pass derivative filter resistor 862B may be configured as binary resistor arrays. Via the control bus 44, the controller 50 may configure the first high pass derivative filter resistor 862A and the second high pass derivative filter resistor 862B to have a resistance level substantially equal to the high pass corner frequency resistance, $R_{HP\_CF}$. The differential capacitor/resistor network 858' has a high pass corner time constant, $\tau_{HF\_CF}$. The high pass corner time constant, $\tau_{HF\_CF}$, is the product of the high pass corner frequency capacitance, $C_{HP\_CF}$, and the high pass frequency resistance, $R_{HP\_CF}$. The controller 50 may be configured to adjust the high pass corner frequency capacitance, $C_{HP\_CF}$, the high pass frequency resistance, $R_{HP\_CF}$, and/or a combination thereof in order to configure the high pass corner time constant, $\tau_{HF\_CF}$. However, in some embodiments, (not shown) the first high pass derivative filter capacitor 860A and the second high pass derivative filter capacitor 860B may be fixed value capacitors while the first high pass derivative filter resistor 862A and the second high pass derivative filter resistor 862B may be programmable. In other embodiments, the first high pass derivative filter capacitor 860A and the second high pass derivative filter capacitor 860B may be programmable while the first high pass derivative filter resistor 862A and the second high pass derivative filter resistor 862B have a fixed value.

A differential Gm feedback compensation circuit 864' includes an inverting input and a non-inverting input. The non-inverting input of the differential Gm feedback compensation circuit 864' may be in communication with the first high pass derivative filter capacitor 860A and the first high pass derivative filter resistor 862A, which form the non-inverted high pass filtered output of the differential capacitor/resistor network 858'. The inverting input of the differential Gm feedback compensation circuit 864' may be in communication with the second high pass derivative filter capacitor 860B and the second high pass derivative filter resistor 862B, which form the inverted high pass filtered output of the differential capacitor/resistor network 858'. The differential Gm feedback compensation circuit 864' may be configured to generate the feedback delay compensation signal 854, $I_{FEEDBACK\_TC}$, based on the derivative output response of the differential capacitor/resistor network 858'. In the case where the slope of the derivative of the differential $V_{RAMP}$ signal is positive, the magnitude of the feedback delay compensation signal 854, $I_{FEEDBACK\_TC}$, is a positive. As a result, the differential Gm feedback compensation circuit 864' sources current when the slope of the derivative of the differential $V_{RAMP}$ signal is positive. In the case where the slope of the derivative of the differential $V_{RAMP}$ signal is negative, the feedback delay compensation signal 854, $I_{FEEDBACK\_TC}$, is a negative current. In other words, the differential Gm feedback compensation circuit 864' sinks current when the slope of the derivative of the $V_{RAMP}$ signal is negative. Similar to the Gm feedback compensation circuit 864, depicted in Figure 4A, the differential Gm feedback compensation circuit 864' also has a Gm feedback compensation transconductance, $Gm_{FEEDBACK\_TC}$, that may be configured by the controller 50. Similar to the feedback delay compensation circuit 852 ,depicted in Figure 4A, the controller 50 may configure the Gm feedback compensation transconductance, $Gm_{FEEDBACK\_TC}$, of the differential Gm feedback compensation circuit 864' to optimize or calibrate the magnitude of the feedback delay compensation signal 854, $I_{FEEDBACK\_TC}$.

Returning to Figure 3A, the application of the feedback delay compensation signal 854, $I_{FEEDBACK\_TC}$, in the multi-level charge pump buck converter 12Q will now be discussed. For the sake of simplicity, and not by way of limitation, the parallel amplifier circuit output current estimate 40, $I_{PAWA\_OUT\_EST}$, is assumed to be substantially equal to the scaled parallel amplifier output current estimate, $I_{PARA\_AMP\_SENSE}$. Accordingly, the parallel amplifier circuit output current estimate 40, $I_{PAWA\_OUT\_EST}$, reflects the magnitude of the parallel amplifier output current, $I_{PARA\_AMP}$, generated by the parallel amplifier 35.

Although the feedback delay compensation signal 854, $I_{FEEDBACK\_TC}$, provides a 90 degree phase lead with respect to the $V_{RAMP}$ signal, the feedback delay compensation circuit 852 may have a signal generation propagation delay associated with generation of the feedback delay compensation signal 854, $I_{FEEDBACK\_TC}$. In order to temporally align the feedback delay compensation signal 854, $I_{FEEDBACK\_TC}$, with the operation of the parallel amplifier 35, the parallel amplifier circuit delay may be adjusted. As an example, in some embodiments, the parallel amplifier circuit 14Q may be configured to add a feedback compensation propagation delay between the first control input 34 and the output of the parallel amplifier 35. As an example, the parallel amplifier circuit delay may be a fixed delay added to the parallel amplifier 35, the parallel amplifier circuitry 32, and/or a combination thereof. In other embodiments, the feedback compensation propagation delay may be added by adjusting the propagation time through a combination of the pre-processing circuitry, the parallel amplifier circuitry 32, the parallel amplifier 35, and/or a combination thereof. In other embodiments, the parallel amplifier circuit delay may be a programmable delay that is configured by the controller 50.

Those skilled in the art will recognize improvements and modifications to the embodiments of the present disclosure. All such improvements and modifications are considered within the scope of the concepts disclosed herein and the claims that follow.

Further aspects and advantages of the invention may be appreciated from the following numbered clauses.

  1. A pseudo-envelope follower power management system with high frequency ripple compensation comprising:

    a switch mode power supply converter configured to:

      generate a switching voltage output; and generate an estimated switching voltage output, which provides an early indication of a future voltage level of the switching voltage output;

    an open loop ripple compensation assist circuit configured to:

      receive the estimated switching voltage output and a $V_{RAMP}$ signal; generate a high frequency ripple compensation current based on the estimated switching voltage output and the $V_{RAMP}$ signal; and apply the high frequency ripple compensation current to a power amplifier supply output to reduce a high frequency ripple current at the power amplifier supply output.

  2. The pseudo-envelope follower power management system with high frequency ripple compensation of clause 1 wherein the high frequency ripple compensation current is generated in a frequency band located substantially near a transmit to receive duplex offset for a band of operation in a communication network.

3. The pseudo-envelope follower power management system with high frequency ripple compensation of clause 2 wherein the switch mode power supply converter includes programmable delay circuitry configured to delay generation of the estimated switching voltage output by a programmable delay period.

4. The pseudo-envelope follower power management system with high frequency ripple compensation of clause 3 wherein the programmable delay period is configured to temporally align the estimated switching voltage output and the $V_{RAMP}$ signal to position a notch in a ripple rejection response of the power amplifier supply output near the transmit to receive duplex offset for the band of operation.

5. The pseudo-envelope follower power management system with high frequency ripple compensation of clause 1 wherein the open loop ripple compensation assist circuit is further configured to generate a scaled high frequency ripple compensation current estimate based on the high frequency ripple compensation current.

6. The pseudo-envelope follower power management system with high frequency ripple compensation of clause 5 wherein the switch mode power supply converter is further configured to receive a parallel amplifier circuit output current estimate, wherein the parallel amplifier circuit output current estimate is based on the scaled high frequency ripple compensation current estimate.

7. The pseudo-envelope follower power management system with high frequency ripple compensation of clause 6 wherein the switch mode power supply converter is further configured to adjust the switching voltage output based on the parallel amplifier circuit output current estimate.

8. The pseudo-envelope follower power management system with high frequency ripple compensation of clause 6 wherein the parallel amplifier circuit output current estimate is further based on a scaled parallel amplifier output current estimate.

9. The pseudo-envelope follower power management system with high frequency ripple compensation of clause 1 further comprising a parallel amplifier configured to:

   receive a $V_{RAMP}$ signal;

   receive a power amplifier supply voltage from the power amplifier supply output;
   generate a parallel amplifier output current based on a difference between the $V_{RAMP}$ signal and the power amplifier supply voltage; and
   apply the parallel amplifier output current to the power amplifier supply output.

10. The pseudo-envelope follower power management system with high frequency ripple compensation of clause 9 wherein the parallel amplifier is further configured to generate a scaled parallel amplifier output current estimate based on the parallel amplifier output current.

11. The pseudo-envelope follower power management system with high frequency ripple compensation of clause 1 wherein the open loop ripple compensation assist circuit comprises:

   a filter network coupled to an operational amplifier and configured to receive the estimated switching voltage output; and
   the operational amplifier configured to receive the $V_{RAMP}$ signal and generate the high frequency ripple compensation current based on the $V_{RAMP}$ signal and the estimated switching voltage output.

12. The pseudo-envelope follower power management system with high frequency ripple compensation of clause 11 wherein the operational amplifier is further configured to provide a scaled high frequency ripple compensation current estimate based on the $V_{RAMP}$ signal and the estimated switching voltage output.

13. The pseudo-envelope follower power management system with high frequency ripple compensation of clause 1 wherein the switch mode power supply converter is configured to operate as a buck converter.

14. The pseudo-envelope follower power management system with high frequency ripple compensation of clause 1 wherein the switch mode power supply converter is configured to operate as a multi-level charge pump buck converter.

15. A method for reducing high frequency ripple currents at a power amplifier supply output comprising:

   generating a switching voltage output;
   generating an estimated switching voltage output, wherein the estimated switching voltage output provides an early indication of a future voltage level of the switching voltage output;
   receiving the estimated switching voltage output and a $V_{RAMP}$ signal;

generating a high frequency ripple compensation current based on the estimated switching voltage output and the $V_{RAMP}$ signal; and

applying the high frequency ripple compensation current to the power amplifier supply output to reduce a high frequency ripple current at the power amplifier supply output.

**Claims**

1. Circuitry comprising:

   • a multi-level converter having a switching voltage output and configured to provide a switching voltage at the switching voltage output, such that a target voltage for a power amplifier supply voltage at a power amplifier supply output is based on the switching voltage, which is based on an early indication of a change of the target voltage; and

   • a feedback delay compensation circuit configured to provide the early indication of the change of the target voltage.

2. The circuitry of claim 1 wherein a power inductive element is coupled between the switching voltage output and the power amplifier supply output.

3. The circuitry of claim 1 further comprising a parallel amplifier circuit, such that the multi-level converter and the parallel amplifier circuit are configured to operate in tandem to generate the power amplifier supply voltage for a radio frequency power amplifier.

4. The circuitry of claim 3 wherein the parallel amplifier circuit is further configured to regulate the power amplifier supply voltage based on a difference between a $V_{RAMP}$ signal and the power amplifier supply voltage.

5. The circuitry of claim 4 wherein the early indication of the change of the target voltage is based on the $V_{RAMP}$ signal.

6. The circuitry of claim 4 wherein the $V_{RAMP}$ signal is representative of required supply modulation information for a power amplifier collector of the radio frequency power amplifier.

7. The circuitry of claim 3 wherein the parallel amplifier circuit has a parallel amplifier output, such that a coupling circuit is coupled between the parallel amplifier output and the power amplifier supply output.

8. The circuitry of claim 7 wherein the coupling circuit comprises an offset capacitive element.

9. The circuitry of claim 1 wherein the feedback delay compensation circuit is further configured to:

   • generate a feedback delay compensation signal based on a derivative of a $V_{RAMP}$ signal; and

   • provide the feedback delay compensation signal to the multi-level converter as the early indication of the change of the target voltage.

10. The circuitry of claim 9 wherein the feedback delay compensation circuit comprises a high pass filter configured to high pass filter the $V_{RAMP}$ signal to generate the derivative of the $V_{RAMP}$ signal.

11. The circuitry of claim 10 wherein the high pass filter is a differential high pass filter.

12. The circuitry of claim 10 wherein the high pass filter has a programmable high pass corner frequency.

13. The circuitry of claim 12 wherein the programmable high pass corner frequency is based on a band of operation of a communication device.

14. A method comprising:

   • providing a switching voltage at a switching voltage output, such that a target voltage for a power amplifier supply voltage at a power amplifier supply output is based on the switching voltage, which is based on an early indication of a change of the target voltage; and

   • providing the early indication of the change of the target voltage.

**FIG. 1A**

EP 2 858 238 A1

FIG. 1B

EP 2 858 238 A1

**FIG. 2A**

**FIG. 2B**

FIG.3A

EP 2 858 238 A1

FIG. 3B

**FIG. 4A**

EP 2 858 238 A1

FIG. 4B

EP 2 858 238 A1

Europäisches
Patentamt

European
Patent Office

Office européen
des brevets

**EUROPEAN SEARCH REPORT**

Application Number

EP 14 19 0851

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | CN 101 867 284 A (HUAWEI TECH CO LTD) 20 October 2010 (2010-10-20)<br><br>& EP 2 579 456 A1 (HUAWEI TECH CO LTD [CN]) 10 April 2013 (2013-04-10)<br>* paragraph [0083] - paragraph [0091]; figure 5 *<br>* paragraph [0077] * | 1,2,5,6, 14<br>3,4,7-13 | INV.<br>H03F1/32<br>H03F1/02<br>H03F3/195<br>H03F3/24<br>H04B17/00<br>H03G3/00<br>H03G3/30<br>H03F3/217 |
| X<br>A | EP 1 317 105 A1 (TEXAS INSTRUMENTS INC [US]) 4 June 2003 (2003-06-04)<br>* the whole document * | 1,5,6,14<br>2-4,7-13 | |
| X | EP 1 557 955 A1 (MATSUSHITA ELECTRIC IND CO LTD [JP]) 27 July 2005 (2005-07-27)<br>* paragraph [0108] - paragraph [0112]; figure 4 * | 1,5,6,14 | |
| X<br>A | GB 2 398 648 A (NUJIRA LTD [GB]) 25 August 2004 (2004-08-25)<br>* page 10, line 3 - page 12, line 13; figures 3,8 * | 1,5,6,14<br>2-4,7-13 | TECHNICAL FIELDS SEARCHED (IPC)<br><br>H03F<br>H04B<br>H03G |
| X<br>A | US 2003/146791 A1 (SHVARTS EMANUIL Y [US] ET AL) 7 August 2003 (2003-08-07)<br>* paragraph [0018] - paragraph [0034]; figure 1A * | 1,5,6,14<br>2-4,7-13 | |
| X | US 2005/079835 A1 (TAKABAYASHI SHINICHIRO [JP] ET AL) 14 April 2005 (2005-04-14)<br>* figure 3 * | 1,5,7,14 | |
| A | US 2009/191826 A1 (TAKINAMI KOJI [US] ET AL) 30 July 2009 (2009-07-30)<br>* the whole document * | 1-14 | |

The present search report has been drawn up for all claims

| Place of search | Date of completion of the search | Examiner |
|---|---|---|
| Munich | 27 February 2015 | Kurzbauer, Werner |

**ANNEX TO THE EUROPEAN SEARCH REPORT
ON EUROPEAN PATENT APPLICATION NO.**   EP 14 19 0851

This annex lists the patent family members relating to the patent documents cited in the above-mentioned European search report.
The members are as contained in the European Patent Office EDP file on
The European Patent Office is in no way liable for these particulars which are merely given for the purpose of information.

27-02-2015

| Patent document cited in search report | | | Publication date | Patent family member(s) | | | Publication date |
|---|---|---|---|---|---|---|---|
| CN | 101867284 | A | 20-10-2010 | CN | 101867284 | A | 20-10-2010 |
| | | | | EP | 2579456 | A1 | 10-04-2013 |
| | | | | US | 2013078939 | A1 | 28-03-2013 |
| | | | | WO | 2011150703 | A1 | 08-12-2011 |
| EP | 1317105 | A1 | 04-06-2003 | EP | 1317105 | A1 | 04-06-2003 |
| | | | | US | 2003107412 | A1 | 12-06-2003 |
| EP | 1557955 | A1 | 27-07-2005 | CN | 1692560 | A | 02-11-2005 |
| | | | | EP | 1557955 | A1 | 27-07-2005 |
| | | | | KR | 20050053591 | A | 08-06-2005 |
| | | | | TW | I240496 | B | 21-09-2005 |
| | | | | US | 2006068697 | A1 | 30-03-2006 |
| | | | | WO | 2004038937 | A1 | 06-05-2004 |
| GB | 2398648 | A | 25-08-2004 | AT | 377865 | T | 15-11-2007 |
| | | | | AU | 2003271975 | A1 | 09-09-2004 |
| | | | | CA | 2516706 | A1 | 02-09-2004 |
| | | | | CN | 1759532 | A | 12-04-2006 |
| | | | | DE | 60317371 | T2 | 28-08-2008 |
| | | | | EP | 1597821 | A1 | 23-11-2005 |
| | | | | GB | 2398648 | A | 25-08-2004 |
| | | | | JP | 4609931 | B2 | 12-01-2011 |
| | | | | JP | 2006514472 | A | 27-04-2006 |
| | | | | KR | 20050116367 | A | 12-12-2005 |
| | | | | US | 2006028271 | A1 | 09-02-2006 |
| | | | | US | 2009128236 | A1 | 21-05-2009 |
| | | | | US | 2012212291 | A1 | 23-08-2012 |
| | | | | US | 2013300513 | A1 | 14-11-2013 |
| | | | | US | 2014232470 | A1 | 21-08-2014 |
| | | | | US | 2014285269 | A1 | 25-09-2014 |
| | | | | WO | 2004075398 | A1 | 02-09-2004 |
| US | 2003146791 | A1 | 07-08-2003 | NONE | | | |
| US | 2005079835 | A1 | 14-04-2005 | AU | 2003272918 | A1 | 23-04-2004 |
| | | | | EP | 1548949 | A1 | 29-06-2005 |
| | | | | US | 2005079835 | A1 | 14-04-2005 |
| | | | | WO | 2004032345 | A1 | 15-04-2004 |
| US | 2009191826 | A1 | 30-07-2009 | NONE | | | |

EPO FORM P0459

For more details about this annex : see Official Journal of the European Patent Office, No. 12/82

**EP 2 858 238 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61421348 A
- US 61421475 A
- US 61469276 A
- US 08991711 A
- US 61325659 A
- US 21840011 A
- US 61376877 A
- US 218400 A